# EUROPEAN PATENT APPLICATION

(11) **EP 0 805 615 A2**
(43) Date of publication of application: **05.11.1997**
(21) Application number: 97500004.3
(22) Date of filing: 14.01.1997
(51) Int. Cl.: H05K 3/28

(54) **Improved printed-circuit board**

(30) Priority: 07.03.1996 ES 9600601 U
(71) Applicant: Eurocir, S.A., 08210 Barbera del Valles, Barcelona (ES)
(72) Inventor: Arola, Juan Llongueras, 08210 Barbera del Valles Barcelona (ES)

(57) **Abstract**

Over a base board (1) made of any appropriate electroinsulating material, such as a phenolic resin or an epoxy resin, are established the classic electroconductive track (2), characteristic in that said tracks (2) are covered by a dielectric layer of ink (4), such as a thermic, photopolymeric or ultraviolet ink, which furthermore fills the grooves or gaps (5) defined between the tracks, thereby increasing the dielectric coefficient existing within said grooves (5) up to levels which render the occurence of electric arcs between them impossible, particularly in adverse environments such as corrosive environment resulting from humid and saline conditions, etc.

## Description

### OBJECT OF THE INVENTION

This invention relates to a printed-circuit board of the type fitted in high intensity power circuits such as the ones used in the automotive industry - namely for the electrical system of automobiles and similar applications - which plate has undergone considerably operational improvement, particularly in regard to the characteristics of the insulation provided between the conductive strips in the presence of adverse weather conditions such as high humidity environments or saline atmospheres.

### BACKGROUND OF THE INVENTION

In practical applications such as the above, printed-circuit boards are used which, instead of the 30 micron thickness of a conventional board, are provided with 150 to 400 micron conductor thicknesses designed to withstand considerably higher loads or intensities.

An electrically insulated base plate, e.g. a phenolic or epoxy resin plate, is used for producing these printed-circuit boards over which an ink mask is applied, followed by etching and stripping, circuit material application and final stamping and dieing.

Thus, in a conventional printed-circuit board of this type, said 150 and 400 micron thick conductive strip side borders or edges remain exposed. In the course the etching process, while the ink is over the circuit, oxidation takes place on the strip edges as a result of a special compound causing a controlled copper oxidation which, when the printed-circuit is welded by the user, prevents adherence of the tin-lead on said conductive strip edges.

Despite the fact that this oxidation process causes a film to be formed which reliably complies with the above function, the electric insulation that exists between adjacent conductive strips is minimal, so that, during the circuit's normal operation in humid and saline atmosphere environments, corrosion is liable to take place between said adjacent conductive strips, thereby rapidly reducing the insulation capability existing between them and giving rise to possible short-circuits.

### DESCRIPTION OF THE INVENTION

The improved printed-circuit board proposed by the invention solves the above problem in a fully satisfactory manner.

Thus, and more particularly, said printed-circuit board is based on a conventional structure like that of any high thickness board of the type previously mentioned, and is characteristic in that its conductive strip edges are covered with an ink which encapsulates the complete circuit.

More specifically, the covering of said conductive strips is by thermic, ultraviolet or photopolymeric inks applied by spray, curtain, roller or silk-screen methods.

### DESCRIPTION OF THE DRAWINGS

To complement this description and in order to help in providing a better understanding of the characteristics of the invention, a set of drawings is attached to this specification wherein the following is represented in an illustrative, non-limiting manner:

Figure 1 shows a schematic partial plane view of a printed-circuit board according to the improvements of the present invention.

Figure 2 shows a considerably enlarged detailed cross-sectional view of the printed-circuit board shown in the previous figure, provided with a pair of adjacent conductive strips.

### PREFERRED EMBODIMENT OF THE INVENTION

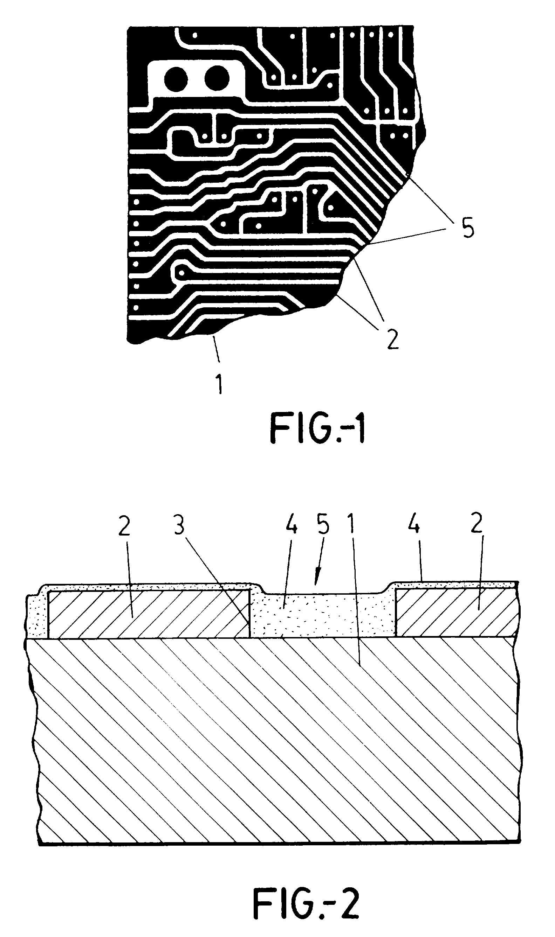

These figures, and particularly figure 2, reveal how a printed-circuit board manufactured according to the improvements of the present invention is structured around a base plate (1) made of an appropriate electric insulating material such as type FR2 phenolic resin, types FR3 or FR4 epoxy resins, or type CEM1 or CEM3 composite materials.

On this base plate (1), and by the use of any conventional means, electrically conductive strips (2) are established which are normally made of copper, although any other suitable electrically conductive material is acceptable, said strips having a considerable thickness, e.g. the above mentioned 400 microns.

Thus, based on this initial and conventional structure, the object of the invention is centered on the fact that said electrically conductive strips (2) present edges (3) that are covered with a layer (4) of dielectric ink such as a thermic, ultraviolet or photopolymeric ink designed to increase the dielectric coefficient inside groove (5) established between the strips up to a degree wherein electric arcs cannot be formed between them, said insulating conditions of the printed-circuit board being maintained in the course of time and in corrosive environments such as high moisture or saline atmospheres.

Referring once more to the dielectric ink layer (4) which covers the electrically conductive strip edges, said ink must comply with the following requirements:
1. Physical
   - Tin-lead bath resistance: ability to withstand 20 seconds at 265°C or 10 seconds at 288°C.
   - Adhesion: IPC scale, class 3.
   - Hardness: 9 H pencil scale.
   - Solvent resistance: IPC-840-b 4.8.6 test.
      * Isopropanol: passes
      * 1,1,1-trichloroethane: passes
      * Trichlorotrifluoroethane/ethanol: passes
      * Alkaline cleaning agents: passes
   - Immersion in dichloromethane during 30 minutes at ambient temperature causes no attack on the cured ink.
2. Electrical
   - Dielectric resistance: 65 kV/mm
   - Surface resistance : 10¹³ ohm
   - Volumetric resistance: 10¹⁵ ohm . cm
   - Insulation resistance: Per IPC SM-840-B, 3.9.1,class 3
   - Electrical corrosion : The part is placed under 100 V DC for 21 days, at 40°C and 95% RH
      -Dielectric constant :at 50 Hz 3.17 at 1 MHz 2.90
   - Dissipation factor : tang at 50 Hz 0.012 at 2 MHz 0.023

In this manner, and according to the object of the invention, a perfect protective covering is achieved against humid and/or saline atmospheres, plus a perfect insulation for the conductive strips forming the circuit, thereby ensuring a long service life for the board with a minimum risk of failure caused by short-circuit.

This description needs not be more extensive for any person experienced on the subject to understand the scope of the invention and the advantages deriving therefrom.

The materials, shape, size and arrangement of the elements may be varied provided no alteration to the essential nature of the invention is involved.

The terms of this specification should be taken in their broad and non-limiting sense.

## Claims

1. Improved printed-circuit board particularly applicable to circuits which must withstand high electrical intensities, such as the circuits used in the automotive industry, wherein on a base plate of dielectric material electrically conductive strips of a considerable thickness - in the order of 400 microns - are established, characterized essentially in that said conductive strips present edges or borders covered by a dielectric, thermic or photopolymeric ink which protects them against the effects of corrosion in humid and/or saline environments, increases the dielectric coefficient between adjacent conductive strips and furthermore provides tin-lead solder saving properties in view that the board is soldered by means of tin-lead wave or conventional methods.
